Europäisches Patentamt

European Patent Office

Office européen des brevets

(11) Veröffentlichungsnummer: **0 490 154 A2**

# EUROPÄISCHE PATENTANMELDUNG

(21) Anmeldenummer: **91120070.7**

(51) Int. Cl.5: **G01R 31/305**

(22) Anmeldetag: **25.11.91**

(30) Priorität: **07.12.90 DE 4039128**

(43) Veröffentlichungstag der Anmeldung:
**17.06.92 Patentblatt 92/25**

(84) Benannte Vertragsstaaten:
**DE FR GB NL**

(71) Anmelder: **SIEMENS AKTIENGESELLSCHAFT**
**Wittelsbacherplatz 2**
**W-8000 München 2(DE)**

(72) Erfinder: **Brunner, Matthias, Dr.**
**Graf-Andechs-Strasse 30**
**W-8011 Kirchheim(DE)**

(54) **Verfahren zur Bestimmung des Ladungszustands eines Probenbereichs.**

(57) Moderne Verfahren zum Testen der elektrischen Eigenschaften von Leiterplatten und keramischen Verbindungsmodulen verwenden Elektronensonden, um Leitungsnetzwerke gezielt aufzuladen und die sich entsprechend der Netzwerkgeometrie und der vorhandenen Kurzschlüsse und Unterbrechungen ausbildende Ladungsverteilung abzutasten. Um den Ladungszustands eines Kontaktpunktes mit Hilfe einer auf diesem positionierten Elektronensonde (PE) innerhalb kurzer Zeit bestimmen zu können, wird vorgeschlagen, die ausgelösten Sekundärelektronen (SE) einem Konverter (KP) zuzuführen, den im Konverter (KP) erzeugten Sekundärteilchenstrom in einem Detektor (MP, V) zu messen und ein den Sekundärteilchenstrom repräsentierendes Signal (I) mit einem Schwellenwert (SW) zu vergleichen. Durch geeignete Vorgabe des Kontaktpunktpotentials und des Schwellenwertes (SW) kann man erreichen, daß nur die von geladenen Kontaktpunkten (2) emittierten Sekundärelektronen (SE) im Konverter (KP) einen für die Erzeugung eines Meßsignals ($U_A$) ausreichend hohen Sekundärteilchenstrom auslösen.

FIG 1

EP 0 490 154 A2

Die aus Scanning Electron Microscopy (1985), S. 991 - 999, Microelectronics Engineering 8 (1988) S. 25 - 35 und der US-A-4 417 203 bekannten Verfahren zum Testen der elektrischen Eigenschaften von Leiterplatten und keramischen Verbindungsmodulen verwenden Elektronensonden, um Leitungsnetzwerke gezielt aufzuladen und die sich entsprechend der Netzwerkgeometrie und der vorhandenen Kurzschlüsse bzw. Unterbrechungen ausbildende Ladungsverteilung abzutasten. Zur Bestimmung des Ladungszustandes eines Kontaktpunktes der Leiterplatte kann man insbesondere die dem jeweiligen Kontaktpunktpotential proportionale Verschiebung der Energieverteilung der von der Elektronensonde ausgelösten Sekundärelektronen in einem energieempfindlichen Detektor messen. Der energieempfindliche Detektor besteht üblicherweise aus einer ein elektrostatisches Gegenfeld erzeugenden Elektrode und einer Szintillator-Photomultiplier-Einheit, deren Ausgangssignal mit Hilfe eines das Potential der Gegenfeldelektrode steuernden Reglers konstant gehalten wird.

Für das Erkennen von Kurzschlüssen und Unterbrechungen in Leitungsnetzwerken ist eine sichere Unterscheidung zwischen geladenen und ungeladenen Kontaktpunkten notwendig, wobei die Messung wegen der Vielzahl der zu überprüfenden Kontaktpunkte jeweils nur wenige Mikrosekunden beanspruchen darf. Dem Regler steht demzufolge nur ein sehr kurzes Zeitintervall von beispielsweise 10 $\mu s$ zur Verfügung, um das Potential der Gegenfeldelektrode dem jeweiligen Kontaktpunktpotential anzupassen. Andererseits ist eine genaue Kenntnis des Kontaktpunktpotentials für das Testen von Leiterplatten nur von untergeordneter Bedeutung.

Der Erfindung liegt die Aufgabe zugrunde, ein Verfahren zur schnellen und sicheren Bestimmung des Ladungszustands eines Probenbereichs anzugeben. Die Erfindung soll insbesondere in den bekannten Verfahren zur Untersuchung der elektrischen Eigenschaften von Leiterplatten und miniaturisierten Verbindungsmodulen angewendet werden können. Diese Aufgabe wird erfindungsgemäß durch ein Verfahren mit den in Patentanspruch 1 angegebenen Merkmalen gelöst.

Der mit der Erfindung erzielbare Vorteil besteht insbesondere darin, daß man Kurzschlüsse und Unterbrechungen in Leiterplatten innerhalb kurzer Zeit nachweisen kann.

Die abhängigen Ansprüche betreffen vorteilhafte Weiterbildungen der im folgenden anhand der Zeichnung erläuterten Erfindung.
Hierbei zeigt:

Fig. 1    den schematischen Aufbau einer Vorrichtung zur Durchführung des erfindungsgemäßen Verfahrens

Fig. 2    die Energieabhängigkeit der Ausbeute emittierter Elektronen

Das aus den Kontaktpunkten 1 bis 3 und der diese Punkte verbindenden Metallisierung LB bestehende Netzwerk der Leiterplatte LP soll daraufhin untersucht werden, ob es eine Unterbrechung aufweist. In einem ersten Verfahrensschritt lädt man daher beispielsweise den Kontaktpunkt 1 mit Hilfe einer auf diesen gerichteten Elektronensonde PE auf und bestimmt anschließend den Ladungszustand aller anderen zum Netzwerk gehörenden Kontaktpunkte 2 bzw. 3. Diese sollten aufgrund der Netzwerkgeometrie ebenfalls geladen sein. Ist dies nicht der Fall, muß notwendigerweise eine Unterbrechung vorliegen.

Ob sich Kontaktpunkt 1 und die mit diesem leitend verbundenen Netzwerkteile durch Bestrahlung mit der Elektronensonde PE positiv oder negativ aufladen, ist abhängig von der Energie E der Primärelektronen und der als Elektronenausbeute bezeichneten Größe $\partial$ , die die mittlere Anzahl der pro einfallendem Primärelektron emittierten sekundären und rückgestreuten Elektronen angibt.

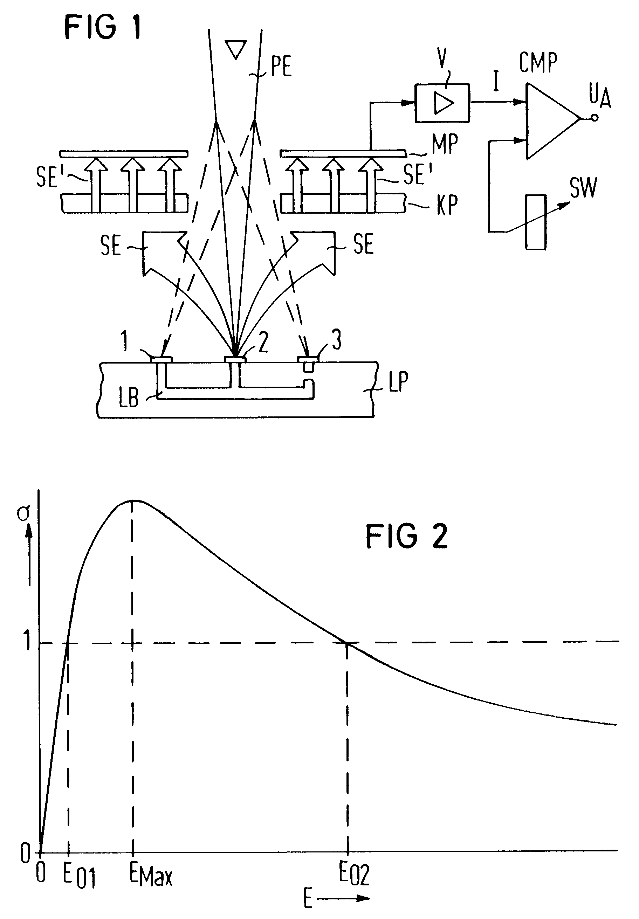

Wie der in Fig. 2 dargestellt Kurvenverlauf zeigt, existieren für viele Materialien zwei Elektronenenergien $E_{01}$ bzw. $E_{02}$, für die $\partial$ jeweils den Wert $\partial (E_{01}) = \partial (E_{02}) = 1$ annimmt. Elektronen dieser Energie vermögen den Ladungszustand einer isolierten Probe nicht zu ändern, da der Strom der Sekundärelektronen und rückgestreuten Elektronen den Primärelektronenstrom gerade kompensieren. Man bezeichnet die Energiewerte $E_{01}$ und $E_{02}$ deshalb auch als Neutralpunktenergien, wobei $E_{01}$ üblicherweise nur wenige 100 eV beträgt und $E_{02}$ im Energiebereich zwischen etwa 1,0 und 4 keV liegt.

Bestrahlt man Kontaktpunkt 1 mit Primärelektronen, deren Energie E von der Neutralpunktenergie $E_{01}$ bzw. $E_{02}$ abweicht, so laden sich alle mit Kontaktpunkt 1 leitend verbundenen Netzwerkteile positiv ($E_{01} < E < E_{02}$, $\partial > 1$) oder negativ ($E < E_{01}$ bzw. $E > E_{02}$, $\partial < 1$) solange auf, bis sich ein stationärer Zustand einstellt. Dieser stationäre Zustand ist für den Fall $E > E_{02}$ erreicht, wenn das sich oberhalb der Leiterplatte LP aufbauende elektrische Feld die Primärelektronen soweit abbremst (negative Aufladung), daß deren Auftreffenergie gerade der Neutralpunktenergie $E_{02}$ entspricht und der Kontaktpunkt bzw. die mit diesem leitend verbundenen Netzwerkteile das negative Potential $V_C$ = ($E_{02}$ - E)/e aufweisen.

Nach dem Ladevorgang wird die Elektronensonde PE auf Kontaktpunkt 2 positioniert, um dessen Ladungszustand abzutasten. Die dort ausgelösten Sekundärelektronen SE besitzen eine vergleichsweise hohe Energie $E_{SE}^2 = E_0 + eV_C$, ($E_0$ := Energie der von einem ungeladenen Probenbereich emittierten Sekundärelektronen) da Kontaktpunkt 2 eine leitende Verbindung mit Kontaktpunkt 1 aufweist und daher ebenfalls auf dem Potential $V_C$

liegt. Die Sekundärelektronen treffen auf eine mit einer Durchtrittsöffnung für die Elektronensonde PE versehene Kanalplatte KP, wo sie ebenfalls Sekundärteilchen SE' auslösen. Deren Anzahl ist wieder von der Energie $E_{SE}^2$ der Sekundärelektronen SE und der für das Kanalplattenmaterial charakteristischen Elektronenausbeute δ abhängig (vgl. Fig. 2). Durch geeignete Wahl des Ladepotentials $V_C$ kann man erreichen, daß die Sekundärelektronenenergie $E_{SE}^2 = E_0 + eV_C$ annähernd der Energie $E_{Max}$ entspricht, bei der die Elektronenausbeute δ einen Maximalwert annimmt. Die von einem geladenen Kontaktpunkt emittierten Sekundärelektronen SE erzeugen dann in der Kanalplatte KP einen entsprechend hohen Strom von Sekundärteilchen SE' ( $δ(E_{SE}^2) > 1$), der lawinenartig verstärkt und in einem aus einer Metallplatte MP und einem Verstärker V bestehenden Detektor gemessen wird. Das verstärkte Sekundärteilchensignal I vergleicht man in einem Komparator CMP mit einem vorzugsweise einstellbaren Schwellenwert SW, der so bemessen ist, daß nur die von einem geladenen Kontaktpunkt emittierten Sekundärelektronen SE ein Ausgangssignal $U_A$ erzeugen.

Die Positionierung der Elektronensonde PE auf Kontaktpunkt 3 hat die Emission von Sekundärelektronen SE der Energie $E_{SE}^3 = E_0 < E_{SE}^2$ zur Folge, da dieser Kontaktpunkt aufgrund der im Netzwerk vorhandenen Unterbrechung ungeladen ist und das Potential $V_C = 0$ aufweist. Die ausgelösten Sekundärelektronen SE erzeugen daher in der Kanalplatte KP auch nur einen kleineren Sekundärteilchenstrom ( $δ(E_{SE}^3) < δ(E_{SE}^2)$), der trotz Verstärkung deutlich unterhalb des im Komparator CMP vorgegebenen Schwellenwertes SW liegt. Anhand des Ausgangssignals $U_A$ des Komparators CMP läßt sich somit unmittelbar feststellen, ob der mit der Elektronensonde PE jeweils beaufschlagte Kontaktpunkt geladen oder ungeladen ist.

Die in der Kanalplatte KP durch auftreffende Rückstreuelektronen ausgelösten Sekundärteilchen SE' tragen ebenfalls zum Detektorsignal I bei. Der von Rückstreuelektronen herrührende und vom Ladungszustand des jeweils abgetasteten Kontaktpunkts unabhängige Signalanteil ist allerdings deutlich kleiner als die den Sekundärelektronen der Energie $E_{SE}^2 = E_0 + eV_C$ zugeordnete Komponente, da die hochenergetischen Rückstreuelektronen in der Kanalplatte vergleichsweise wenige Sekundärteilchen SE' auslösen.

Die Erfindung ist selbstverständlich nicht auf das beschriebene Ausführungsbeispiel beschränkt. So kann man den in Fig. 1 dargestellten Detektor auch durch eine seitlich oberhalb der Kanalplatte KP angeordnete Szintillator-Photomultiplier-Einheit ersetzen. Anstelle der Kanalplatte KP kann auch eine beispielsweise aus Metall bestehende und gegebenenfalls mit einem die Sekundärelektronenemission begünstigenden Material beschichtete Platte Verwendung finden. Als Beschichtung kommt insbesondere eine sauerstoffaktivierte Ag-Mg-Legierung in betracht.

Die Energie der von einem geladenen Probenbereich emittierten Sekundärelektronen muß nicht notwendigerweise der Energie $E_{Max}$ entsprechen. Es ist lediglich sicherzustellen, daß die an geladenen bzw. ungeladenen Kontaktpunkten gemessenen Signale I sich möglichst deutlich voneinander unterscheiden. Dies ist insbesondere dann gewährleistet, wenn man die Energie der von geladenen Kontaktpunkten ausgehenden Sekundärelektronen SE auf Werte $E_{SE} = E_0 + eV_C \, E_{Max}$ beschränkt.

Der Vergleich zwischen den an geladenen und ungeladenen Kontaktpunkten erzeugten Signalen muß nicht notwendigerweise mit einem Komparator durchgeführt werden sondern kann, nach Analog-Digitalwandelung, in einem Rechner erfolgen.

## Patentansprüche

1. Verfahren zur Bestimmung des Ladungszustands eines Probenbereichs
   **dadurch gekennzeichnet,**
   - daß der Probenbereich (2) mit primären Korpuskeln bestrahlt und dadurch zur Emission von Sekundärelektronen (SE) angeregt wird,
   - daß die Sekundärelektronen (SE) einem Konverter (KP) zugeführt werden um dort Sekundärteilchen (SE') auszulösen,
   - daß der im Konverter (KP) erzeugte Sekundärteilchenstrom in einem Detektor (MP, V) gemessen wird
   - und daß ein den Sekundärteilchenstrom repräsentierendes Signal (I) mit einem Schwellenwert (SW) verglichen wird.

2. Verfahren nach Anspruch 1,
   **dadurch gekennzeichnet,**
   daß eine Kanalplatte (KP) als Konverter verwendet wird.

3. Verfahren nach Anspruch 1,
   **dadurch gekennzeichnet,**
   daß eine Metallplatte als Konverter verwendet wird.

4. Verfahren nach einem der Ansprüche 1 bis 3,
   **dadurch gekennzeichnet,**
   daß der Sekundärteilchenstrom in einem oberhalb oder unterhalb des Konverters (KP) angeordneten Detektor (MP, V) gemessen wird.

5. Verfahren nach einem der Ansprüche 1 bis 4,
   **dadurch gekennzeichnet,**
   daß der Sekundärteilchenstrom mit Hilfe einer Metallplatte (MP) gemessen wird.

6. Verfahren nach Anspruch 3,
   **dadurch gekennzeichnet,**
   daß die Metallplatte mit einer die Sekundärteilchenausbeute ($\delta$) erhöhenden Schicht belegt
   wird.

# FIG 1

# FIG 2